**Europäisches Patentamt**

**European Patent Office**

**Office européen des brevets**

(19)

(11) Numéro de publication : **0 449 740 A1**

(12)

# DEMANDE DE BREVET EUROPEEN

(21) Numéro de dépôt : **91400869.3**

(22) Date de dépôt : **29.03.91**

(51) Int. Cl.$^5$ : **H01J 37/12**, G21K 1/087, H01J 27/26

(30) Priorité : 30.03.90 FR 9004076

(43) Date de publication de la demande :
**02.10.91 Bulletin 91/40**

(84) Etats contractants désignés :
**AT BE CH DE DK ES GB GR IT LI LU NL SE**

(71) Demandeur : **ORSAY PHYSICS**
**29, rue Jean Rostand**
**F-91893 Orsay Cédex (FR)**

(72) Inventeur : **Sudraud, Pierre**
**5, rue de Foisnard**
**F-91410 Saint Cyr Sous Dourdan (FR)**

(74) Mandataire : **Thibon-Littaye, Annick**
**Cabinet A. THIBON-LITTAYE 11 rue de l'Etang**
**F-78160 Marly-le-Roi (FR)**

(54) **Dispositif de focalisation d'un faisceau de particules chargées.**

(57)    La présente invention concerne un dispositif de focalisation pour faisceau de particules chargées électriquement, comportant une pluralité d'électrodes en couronnes annulaires associées pour former des lentilles électrostatiques ayant un effet résultant convergent sur ledit faisceau à l'issue d'une tête de focalisation. Il comporte au moins une première et une seconde électrodes annulaires (11, 12), situées dans un corps (9) du dispositif, et au moins une troisième et une quatrième électrodes annulaires (13, 14) situées à distance dudit corps (9) dans ladite tête (8), en ce que ladite seconde électrode et ladite troisième électrodes sont électriquement reliées entre elles par un tube conducteur d'alimentation sous haute tension (32), ledit tube (32) étant disposé longitudinalement à l'intérieur d'une électrode tubulaire extérieure (34) formant enveloppe de résistance mécanique pour ladite tête (8) et terminée par ladite quatrième électrode annulaire (14), et en ce que ladite troisième électrode (13) est formée par une pièce conductrice intérieure (33) qui est en liaison rigide isolante avec ladite électrode tubulaire extérieure dans ladite tête.

EP 0 449 740 A1

Jouve, 18, rue Saint-Denis, 75001 PARIS

Fig. 2

La présente invention concerne la réalisation des dispositifs de focalisation pour faisceaux de particules chargées qui sont utilisés dans l'industrie en association avec des canons à électrons ou sources d'ions, de type à gaz ou à métal liquide, soit plus généralement toutes sources de toutes particules porteuses de charges électriques.

Le propos de ces dispositifs de focalisation est, de manière classique, de concentrer un faisceau d'origine, émanant par exemple d'une source produisant un faisceau divergent ou parallèle, pour ramener un maximum de densité de particules vers un point focal, ou une zone focale de section plus réduite que celle du faisceau d'origine. Un tel besoin de concentration par focalisation se fait sentir couramment, par exemple, dans les applications d'usinage ou de traitement de surface au moyen de sources d'ions.

Il est bien connu dans ce domaine que pour focaliser un faisceau de particules chargées, on soumet ce faisceau à l'action d'un champ électrique tendant à dévier les faisceaux élémentaires périphériques en direction de l'axe du faisceau global. C'est pourquoi on fait passer le faisceau à travers des électrodes annulaires portées à des potentiel électriques différents dans une colonne d'optique corpusculaire. Les électrodes successives constituent ensemble ce qu'il est convenu d'appeler une lentille électrostatique, par analogie avec les systèmes optiques.

Pour satisfaire simultanément à des exigences de positionnement relatif des points conjugués du système de focalisation et de valeurs de grandissement, on est conduit à utiliser des colonnes optiques qui comportent trois électrodes associées, pour assurer une focalisation appropriée du faisceau sur une cible sur laquelle il doit agir. Pour permettre d'accéder à la cible par d'autres dispositifs, par exemple pour en extraire des ions éjectés par le faisceau focalisé, ces électrodes doivent être disposées dans une tête de focalisation de faible encombrement. L'alimentation électrique de ces électrodes pose alors des problèmes complexes de réalisation technologiques, qui sont d'autant plus sensibles que les hautes tensions appliquées pour obtenir l'énergie voulue sur la cible doivent être plus élevées. Tel est le cas en particulier lors de l'emploi de sources d'ions à métal liquide, utilisées pour produire des faisceaux très fins et très intenses à proximité immédiate de la cible, car ceci requiert une grande rigidité mécanique des électrodes sous un très faible encombrement.

Pour résoudre mieux que les dispositifs de focalisation antérieurs les différents problèmes qui se posent dans la pratique des applications de telles sources, la présente invention propose un dispositif de focalisation pour faisceau de particules chargées électriquement, comportant une pluralité d'électrodes en couronnes annulaires associées pour former des lentilles électrostatiques ayant un effet résultant convergent sur ledit faisceau à l'issue d'une tête de focalisation, caractérisé en ce qu'il comporte au moins une première et une seconde électrodes annulaires situées dans un corps du dispositif, et au moins une troisième et une quatrième électrodes annulaires situées à distance dudit corps dans ladite tête, en ce que ladite seconde électrode annulaire et ladite troisième électrode annulaire sont électriquement reliées entre elles par un tube conducteur d'alimentation sous haute tension, ledit tube étant disposé longitudinalement à l'intérieur d'une électrode tubulaire extérieure formant enveloppe de résistance mécanique pour ladite tête et terminée par ladite quatrième électrode annulaire, et en ce que ladite troisième électrode annulaire est formée par une pièce conductrice intérieure qui est en liaison rigide isolante avec ladite électrode tubulaire extérieure dans ladite tête.

Dans un mode de réalisation préféré de l'invention, ladite tête dépasse dudit corps au-delà d'un prolongement tubulaire dudit corps dans lequel ladite électrode tubulaire extérieure est montée en pied et qui comporte des moyens de fixation étanche sur une enceinte de traitement recevant ladite tête.

Conformément à des caractéristiques secondaires de l'invention, il peut être utile de prévoir en outre une couronne de lentille de déflexion finale du faisceau focalisé (post-déflexion), laquelle est alors avantageusement montée en liaison isolante sur l'électrode tubulaire extérieure, en particulier ladite quatrième couronne, et peut être notamment alimentée par des pistes de dépôt conducteur formées extérieurement sur ladite électrode tubulaire extérieure, par des fils logés dans des rainures creusées longitudinalement dans la surface extérieure de celle-ci, ou par toute solution équivalente utilisant cette électrode comme support.

On décrira maintenant plus en détails une forme de réalisation particulière de l'invention qui en fera mieux comprendre les caractéristiques essentielles et les avantages, étant entendu toutefois que cette forme de réalisation est choisie à titre d'exemple et qu'elle n'est nullement limitative.

On verra en particulier que le dispositif de l'invention présente de préférence des caractéristiques relatives au fonctionnement optique, avec notamment la présence d'un diaphragme interposé sur le trajet du faisceau encore dans le corps du dispositif, entre les deux ensembles de couronnes, et d'autres caractéristiques concernant plus spécifiquement la construction mécanique, telles que celle qui portent sur le mode de montage des couronnes sur leurs supports.

La description de cette forme de réalisation suivant l'invention est illustrée par les dessins annexés, dans lesquels :
   – la figure 1 illustre schématiquement le principe de la colonne optique de focalisation d'un faisceau de particules chargées constituée suivant l'invention ;
   – la figure 2 représente schématiquement un dispositif de focalisation suivant l'invention monté sur une chambre d'expérience utilisant une source d'ions ;

– la figure 3 représente un mode de construction illustrant le montage d'une tête de focalisation selon l'invention dans le corps de ce dispositif.

Pour assurer la focalisation d'un faisceau de particules chargées conformément à l'invention, on utilise une série d'électrodes en forme de couronnes annulaires parallèles qui se laissent traverser axialement par le faisceau. Celui-ci peut être par exemple un faisceau d'ions issu d'une source au gallium.

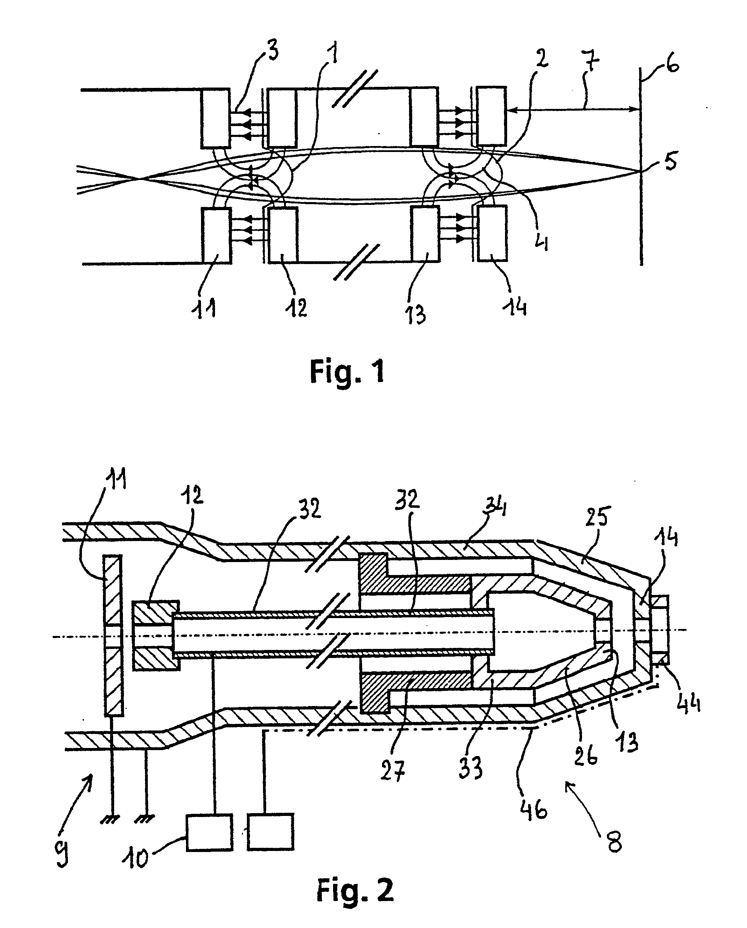

On trouve ainsi sur la colonne d'optique corpusculaire de la figure 1, quatre électrodes en forme de couronnes annulaires, groupées en deux couples qui réalisent chacun une lentille électrostatique, ou dioptre. Ces quatre électrodes ou couronnes sont conformées, en épaisseur et en diamètre de l'ouverture centrale et en conicité, pour qu'en liaison avec la distance entre deux couronnes accouplées et avec les valeurs de tensions appliquées, chaque dioptre ait sur le faisceau un effet convergent suffisant pour obtenir en résultante la puissance de convergence souhaitée, tout en minimisant les coefficients d'aberration chromatique et sphérique. Quand le faisceau d'origine est plutôt divergent que parallèle ou convergent, ce qui sera souvent le cas, le faisceau peut être parallèle ou sensiblement parallèle dans son trajet entre les deux dioptres, lequel peut être relativement long.

Pour constituer le premier dioptre, on applique à la deuxième électrode 12 une tension élevée par rapport à celle de la première électrode 11, laquelle est portée ici au potentiel zéro. Quand le faisceau de particules chargées traverse axialement les deux couronnes, qui sont proches l'une de l'autre, les effets divergents et convergents auxquels les particules sont soumises par suite des actions de freinage et accélération, qui sont plus importants sur les faisceaux élémentaires périphériques, par rapport aux faisceaux élémentaires situés dans l'axe, produisent en résultante un effet global qui est toujours convergent, en conformité avec les propriétés connues des lentilles électrostatiques. Le faisceau qui sort de ce premier dioptre est d'angle d'ouverture faible, ou de préférence parallèle, jusqu'à parvenir à la troisième électrode 13. Celle-ci est au même potentiel élevé que la seconde électrode 12. La quatrième électrode 14 est à nouveau au potentiel zéro ; elle constitue avec la troisième le second dioptre, qui a également un effet convergent sur le faisceau. On a fait apparaître sur la figure des surfaces équipotentielles 1 et 2, respectivement au niveau du premier dioptre et du second dioptre, ainsi que des lignes de champ 3, 4, qui font ressortir la courbure de ces lignes de champ au centre des électrodes par suite des effets de bord.

Le système optique global fait converger le faisceau vers un point focal 5. Sur la figure 1, celui-ci a été représenté comme étant situé sur une surface 6, celle par exemple d'un objet représentant la cible sur laquelle on désire faire agir le faisceau ponctuellement. La distance 7 entre la dernière électrode du dispositif de focalisation et la surface 6 est ce que l'on appelle la distance frontale ou "working distance" en anglais. La nature des sources utilisées et les conditions de fonctionnement du système de focalisation demandent que cette distance soit minimale, pour minimiser les conséquences d'aberrations chromatiques et sphériques, d'où les problèmes d'accessibilité que l'invention s'est proposé de résoudre, quand par exemple, dans un micro-analyseur, les particules éjectées de la cible par les ions du faisceau focalisé doivent être immédiatement reprises par une lentille collectrice et renvoyées vers un autre instrument.

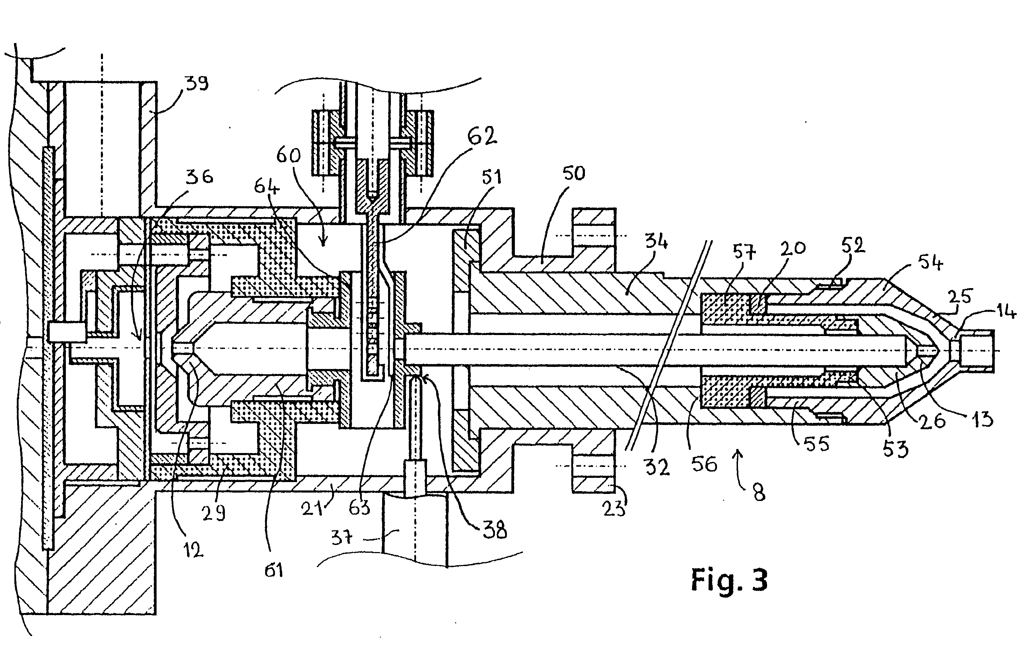

Conformément à la réalisation illustrée par les figures 2 et 3, le premier dioptre 1 se situe au pied 9 du système de focalisation, à l'intérieur d'un corps 21 duquel dépasse une tête de focalisation 8 où se situe le second dioptre. L'ensemble du dispositif peut être monté sur une chambre d'expérience sous vide, par une bride de fixation 23 solidaire du corps 21.

Il peut être utile de rappeler ici que les dispositifs de focalisation de l'art antérieur comportaient des lentilles électrostatiques comprenant trois électrodes tubulaires terminées en couronnes annulaires, de sorte que la "tête" de focalisation devrait avoir un diamètre suffisant pour loger et alimenter trois électrodes au moins, l'électrode centrale étant portée à une tension élevée. Conformément au dispositif de l'invention, on ne trouve plus que deux parties actives d'électrodes (couronnes annulaires 13 et 14) sous potentiels différents à l'intérieur de la tête de focalisation 8. Ceci permet de réduire sensiblement l'encombrement du dispositif au niveau de la tête de focalisation, malgré l'épaisseur de rigidité qu'il est nécessaire de donner aux électrodes tubulaires alimentant les couronnes tubulaires et l'écartement à respecter entre elles pour éviter tout risque de claquage entre haute et basse tensions.

Ainsi, conformément à la figure 2, la dernière électrode et couronne annulaire 14 sont constituées par l'extrémité en forme de disque annulaire d'un tube cylindrique rétréci en cône 25 vers son extrémité, constituant l'électrode tubulaire extérieure 34 selon l'invention. Cette électrode est au potentiel zéro. C'est elle qui assume la résistance mécanique de la tête du dispositif et son montage dans le corps 21 (figure 3).

L'électrode en couronne annulaire 13, associée à la couronne 14 pour former une lentille électrostatique, est constituée d'une manière analogue par un disque annulaire terminant l'extrémité conique 26 formant une électrode tubulaire intérieure 33. Cette dernière est cependant relativement courte. Elle est montée sur la partie cylindrique de l'électrode tubulaire 34 par une pièce 27 en céramique isolante. Cette pièce assure la solidité du montage et la rigidité de la couronne 13 dans sa disposition par rapport à l'électrode extérieure et à la couronne 14, les deux couronnes 13 et 14 étant aussi proches l'une de l'autre que le permettent les risques de claquage.

La haute tension alimentant l'électrode interne jusqu'à la couronne 13 y est amenée depuis l'extérieur de la tête de focalisation par un tube 32. Ce tube est réalisé sous forme d'un simple cylindre de faible épaisseur, car son rôle est exclusivement de conduire l'électricité, sans besoin de résistance mécanique. Il est alimenté à partir d'une source de tension 10.

Le tube 32 est disposé suivant l'axe du dispositif de focalisation et il s'étend sur une longueur qui va de la couronne 13 jusqu'à l'intérieur du corps 21. Il entoure le faisceau de particules chargées (qui reste à potentiel constant) depuis le premier dioptre 11,12 jusqu'au second dioptre où il se termine en contact électrique avec l'électrode 26. A son autre extrémité, le tube 32 est engagé dans la couronne 12 de manière à être en contact électrique avec elle. La couronne 12 est associée à la couronne 11 pour former une lentille électrostatique d'une manière qui peut être quelconque en soi classique, car les problèmes d'encombrement à ce niveau sont moins sensibles que pour la tête du dispositif elle-même.

Dans la réalisation plus particulière de la figure 3, les couronnes 11 et 12 ont été représentées intégrées à un ensemble mécanique 29, qui comporte également une lentille électrostatique 36 d'ajustage de la focale du premier dioptre et qui est disposé à l'intérieur du corps 21. On a représenté par ailleurs une broche d'alimentation électrique 37, destinée à être reliée à une source électrique sous haute tension pour alimenter le tube 32 par l'intermédiaire d'un contact électrique à bille 38.

La figure 3 illustre d'autre part un mode de construction particulier de la tête de focalisation proprement dite, conçu pour faciliter le montage des différents éléments les uns sur les autres avant de faire le vide dans l'enceinte d'expérience. On y voit que le corps 21 comporte un prolongement tubulaire 50 jusqu'à la bride 23, prolongement dans lequel l'électrode tubulaire extérieure 34 est mise en place de l'intérieur du corps 21. Un épaulement annulaire extérieur de l'électrode 34 vient buter sur un épaulement correspondant du corps 21, contre lequel il est maintenu appliqué par un couvercle 51 fixé dans le corps avec interposition d'un joint isolant. Ce couvercle, s'il est réalisé en matière isolante, peut également servir à maintenir l'extrémité correspondante du tube 32 dans l'axe du dispositif.

A l'extrémité opposée, c'est-à-dire à l'extrémité de la tête de focalisation, le tube 32 est engagé dans la pièce conductrice constituant l'électrode 26 en assurant le contact électrique avec elle. Cette électrode est en fait réduite en dimension à un simple embout fixé en 53 sur la pièce isolante 27, de forme générale cylindrique. D'une manière analogue pour l'électrode tubulaire extérieure 34, celle-ci comporte un embout séparable 54 qui forme l'extrémité conique 25 terminée par la couronne 14. L'embout 54, réalisé par exemple dans le même matériau métallique conducteur que la partie principale cylindrique de l'électrode 34, est vissé à l'intérieur de celle-ci en 52 à son extrémité. L'embout 54 comporte là un prolongement tubulaire 55 qui assure la rigidité mécanique du montage par l'épaisseur de paroi, tout en laissant, lors du vissage, une certaine latitude de réglage pour l'écart entre les deux couronnes 13 et 14, grâce à la rondelle d'appui 20.

La pièce isolante 27, en général en matériau céramique, sur laquelle est brasée l'électrode 26, aura été mise en place dans l'électrode extérieure 34 préalablement au montage de l'embout 54. Elle est positionnée en butée sur un épaulement 56 formé à l'intérieur de l'électrode 34, au niveau d'une couronne extérieure 57 de section plus importante que le reste de la pièce 27. Un joint annulaire élastique 20 est interposé entre la couronne 57 et la face terminale du prolongement 55 de l'embout 54 qui vient buter sur lui.

Sur la figure 3 on voit encore une tubulure 39 qui permet de faire le vide à l'intérieur du corps 21. Le vide peut également être fait par ailleurs dans l'enceinte d'expérience à laquelle le dispositif est accouplé et qui n'a pas été représenté.

Enfin, suivant une autre caractéristique de l'invention, un diaphragme optique 60, au même potentiel que le tube de liaison, a été incorporé sur le trajet du faisceau utilisé, pour permettre de définir de manière variable la section du faisceau. Un tel diaphragme n'était pas envisagé dans la description faite en référence à la figure 2. Conformément à la réalisation de la figure 3, il est interposé à l'intérieur du corps 1, mais entre les deux dioptres du système de focalisation optique. Plus précisément, il intervient en intermédiaire dans le montage de l'extrémité correspondante du tube 32 avec une électrode tubulaire 61 qui se termine en cône vers la couronne 12. Les détails du montage sont tels qu'illustrés sur la figure 3.

La définition du diamètre du faisceau dont on rappellera qu'il est parallèle à ce niveau, est effectuée classiquement en déplaçant transversalement un porte-diaphragme 62, percé de plusieurs orifices de diamètres différents. Le déplacement du porte-diaphragme 62 est assuré de l'extérieur du dispositif par des moyens, non représentés. Un contact métallique 63 la porte au même potentiel électrique qu'une bague centrale 64 percée d'un alésage transversal pour le passage du porte-diaphragme 62. Cette bague 64 est reliée à l'alimentation haute tension par le contact à bille 38 et c'est sur elle que sont montées, d'une part l'extrémité du tube 32 et d'autre part l'électrode 61.

Pour compléter le dispositif de focalisation, il est avantageux, comme illustré par la figure 3, d'y ajouter un post-déflecteur 44. Celui-ci est constitué de quatre plaquettes orientées longitudinalement et réparties autour de l'axe pour former une couronne annulaire, la tranche des plaquettes étant collée par une couche isolante sur la couronne 14 en bout de la tête de focalisation. Elle est alimentée en courant électrique par des pistes conductrices 46 (figure 2), déposées sur une couche isolante sur la surface extérieure de l'électrode tubulaire 34 qui forme l'enveloppe de résistance mécanique de la tête 8.

Une variante parfois préférable consiste à utiliser plutôt des fils conducteurs classiques, isolés par des tubes d'alumine, qui sont logés dans des rainures creusées sur la surface extérieure de l'électrode tubulaire extérieure 34.

Naturellement, l'invention n'est en rien limitée par les particularités qui ont été spécifiées dans ce qui précède ou par les détails du mode de réalisation particulier choisi pour illustrer l'invention. Toutes sortes de variantes peuvent être apportées à la réalisation particulière qui a été décrite à titre d'exemple et à ses éléments constitutifs sans sortir pour autant du cadre de l'invention. Cette dernière englobe ainsi tous les moyens constituant des équivalents techniques des moyens décrits ainsi que leurs combinaisons.

## Revendications

1. Dispositif de focalisation pour faisceau de particules chargées électriquement, comportant une pluralité d'électrodes en couronnes annulaires associées pour former des lentilles électrostatiques ayant un effet résultant convergent sur ledit faisceau à l'issue d'une tête de focalisation, caractérisé en ce qu'il comporte au moins une première et une seconde électrodes annulaires (11, 12), situées dans un corps (9) du dispositif, et au moins une troisième et une quatrième électrodes annulaires (13, 14) situées à distance dudit corps (9) dans ladite tête (8), en ce que ladite seconde électrode et ladite troisième électrodes sont électriquement reliées entre elles par un tube conducteur d'alimentation sous haute tension (32), ledit tube (32) étant disposé longitudinalement à l'intérieur d'une électrode tubulaire extérieure (34) formant enveloppe de résistance mécanique pour ladite tête (8) et terminée par ladite quatrième électrode annulaire (14), et en ce que ladite troisième électrode (13) est formée par une pièce conductrice intérieure (33) qui est en liaison rigide isolante avec ladite électrode tubulaire extérieure dans ladite tête.

2. Dispositif selon la revendication 1, caractérisé en ce que ladite tête (8) dépasse dudit corps (9) au-delà d'un prolongement tubulaire dudit corps dans lequel ladite électrode tubulaire extérieure est montée en pied et qui comporte des moyens de fixation étanche sur une chambre d'expérience recevant ladite tête.

3. Dispositif selon la revendication 1 ou 2, caractérisé en ce qu'il comporte en outre une couronne de lentille de post-déflexion dudit faisceau (44), montée en liaison isolante en bout de ladite électrode tubulaire extérieure (34).

4. Dispositif selon la revendication 3, caractérisé en ce que ladite lentille de post-déflexion (44) est collée sur ladite quatrième électrode annulaire.

5. Dispositif selon la revendication 3 ou 4, caractérisé en ce que ladite couronne de post-déflexion (44) est alimentée par des pistes (46) de dépôt conducteur formées extérieurement sur ladite électrode tubulaire extérieure (34), en liaison isolante avec elle.

6. Dispositif selon la revendication 3 ou 4, caractérisé en ce que ladite couronne de post-déflexion (44) est alimentée par des fils logés dans des rainures creusées dans la surface extérieure de ladite électrode tubulaire extérieure (34).

7. Dispositif suivant l'une quelconque des revendications précédentes, caractérisé en ce qu'il comporte en outre un diaphragme.

8. Dispositif suivant l'une quelconque des revendications précédentes, caractérisé en ce que ladite quatrième électrode annulaire (14) est solidaire d'un embout conique (54), monté par vissage en bout d'une partie cylindrique de ladite électrode tubulaire extérieure (34).

9. Dispositif suivant l'une quelconque des revendications précédentes, caractérisé en ce que ladite troisième électrode annulaire (13) est solidaire d'un embout conique (26), fixé en bout d'une pièce cylindrique isolante (27), elle-même montée à l'intérieur de ladite électrode tubulaire extérieure (34).

Fig. 1

Fig. 2

Fig. 3

Office européen
des brevets

**RAPPORT DE RECHERCHE EUROPEENNE**

Numero de la demande

EP    91 40 0869

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| A | FR-A-935241 (COMPAGNIE GENERALE DE TELEGRAPHIE SANS FIL) <br> * page 2, lignes 31 - 42; figure 3 * <br> --- | 1 | H01J37/12 <br> G21K1/087 <br> H01J27/26 |
| A | DE-C-927523 (ALLGEMEINE ELEKTICITÄTS-GESELLSHAFT) <br> * le document en entier * <br> --- | 1 | |
| A | PATENT ABSTRACTS OF JAPAN <br> vol. 10, no. 95 (E-395)(2152) 12 avril 1986, <br> & JP-A-60 236443 (SHIMAZU SEISAKUSHO) 25 novembre 1985, <br> * le document en entier * <br> --- | | |
| A | PATENT ABSTRACTS OF JAPAN <br> vol. 11, no. 271 (E-536)(2718) 03 septembre 1987, <br> & JP-A-62 73544 (SHIMADZU CORP) 04 avril 1987, <br> * le document en entier * <br> ----- | 1 | |

**DOMAINES TECHNIQUES RECHERCHES (Int. Cl.5 )**

H01J
G21K

Le présent rapport a été établi pour toutes les revendications

| Lieu de la recherche | Date d'achèvement de la recherche | Examinateur |
|---|---|---|
| LA HAYE | 11 JUILLET 1991 | SCHAUB G.G. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)